(19) Europäisches Patentamt
European Patent Office
Office européen des brevets

(11) **EP 1 814 127 A1**

(12) **EUROPEAN PATENT APPLICATION**
published in accordance with Art. 158(3) EPC

(43) Date of publication:
**01.08.2007 Bulletin 2007/31**

(51) Int Cl.:
**H01B 13/00** (2006.01)     **H01B 12/10** (2006.01)

(21) Application number: **05807108.5**

(22) Date of filing: **15.11.2005**

(86) International application number:
**PCT/JP2005/020918**

(87) International publication number:
**WO 2006/054538 (26.05.2006 Gazette 2006/21)**

(84) Designated Contracting States:
**CH DE DK FR GB IT LI**

(30) Priority: **19.11.2004 JP 2004336109**

(71) Applicant: **Sumitomo Electric Industries, Ltd.**
**Osaka-shi, Osaka 541-0041 (JP)**

(72) Inventors:
• **KATO, T.,**
**Osaka Works Sumitomo Electr. Ind. Ltd.**
**Osaka-shi Osaka 5548511 (JP)**

• **KOBAYASHI, S.,**
**Osaka Works Sumitomo Elec. Ind. Ltd**
**Osaka-shi Osaka 5548511 (JP)**

(74) Representative: **Kreutzer, Ulrich et al**
**Cabinet Beau de Loménie**
**Bavariaring 26**
**80336 München (DE)**

(54) **METHOD FOR PRODUCING OXIDE SUPERCONDUCTING WIRE**

(57)     A method of manufacturing an oxide superconducting wire comprises the following steps: A wire formed by covering raw material powder for an oxide superconductor with a metal is prepared (S1 to 4). The wire is rolled (S5). The wire is heat-treated in a pressurizing atmosphere (S6) after the rolling (S5). The draft of the wire in the rolling (S5) is at least 50 % and not more than 80 %. Thus, superconductivity can be improved.

FIG.2

```
CHARGE RAW MATERIAL POWDER
INTO METAL PIPE                      — S1

WIREDRAW SINGLE-FILAMENTARY WIRE     — S2

MULTIFILAMENTARY FITTING             — S3

WIREDRAW MULTIFILAMENTARY WIRE       — S4

ROLLING                              — S5

HEAT TREATMENT                       — S6

OXIDE SUPERCONDUCTING WIRE
```

## EP 1 814 127 A1

## Description

### Technical Field

The present invention relates to a method of manufacturing an oxide superconducting wire, and more specifically, it relates to a method of manufacturing an oxide superconducting wire capable of improving superconductivity.

### Background Art

In general, a method of obtaining an oxide superconducting wire by heat-treating a wire obtained by charging raw material powder for an oxide superconductor into a metal pipe and thereafter performing wiredrawing and rolling on the metal pipe for sintering the raw material powder for an oxide superconductor is known as a method of manufacturing an oxide superconducting wire. However, there has been such a problem that superconductivity of the obtained oxide superconducting wire reduces due to blisters formed in the wire in the aforementioned heat treatment step for sintering.

In this regard, a technique of improving superconductivity by heat-treating a wire in a pressurizing atmosphere has recently been in the process of development. For example, Japanese Patent Laying-Open No. 5-101723 (Patent Literature 1) proposes a method of manufacturing an oxide superconducting wire by heat-treating a metal pipe charged with powder of an oxide superconductor or a flat body thereof in a pressurizing atmosphere for sintering the powder of the oxide superconductor. The aforementioned literature describes that a wire excellent in superconductivity is obtained by performing pressurization/heat treatment according to this method.

More specifically, the metal pipe charged with the powder of the oxide superconductor is stored in a heat-resistant/pressure-resistant closed vessel, in order to attempt to prevent blisters in sintering due to rise of the internal pressure increasing following temperature rise in the closed vessel. The aforementioned literature describes that the current internal pressure can be obtained from an equation of state of gas or the like such that an internal pressure of about 4 atm. can be obtained at a heating temperature of about 900°C, for example.

Japanese Patent No. 2592846 (Japanese Patent Laying-Open No. 1-30114) (Patent Literature 2) proposes a method of manufacturing an oxide superconducting conductor by holding a metal pipe charged with oxide superconducting powder or the like in a high pressure state at least either during heat treatment or after the heat treatment. The aforementioned literature describes that partial separation on the interface between an oxide superconductor and the metal pipe caused in sintering can be eliminated by setting the metal pipe in the high pressure state according to this method.

More specifically, the metal pipe can be press-bonded toward a sintered body by holding the metal pipe charged with the oxide superconducting powder in a high pressure state of 500 to 2000 $kg/cm^2$ (about 50 to 200 MPa) at least either during the heat treatment or after the heat treatment. Thus, when the superconductor partially causes quenching, heat resulting from this quenching can be swiftly removed. In addition, it is also possible to prevent deterioration of superconductivity resulting from distortion caused by stress concentration formed by a separating portion.

As described above, the metal pipe charged with the raw material powder is rolled in a step of manufacturing an oxide superconducting wire. This rolling is performed for the purpose of improving the superconductivity of the obtained oxide superconducting wire by increasing the density of the raw material powder in the metal pipe. For this purpose, conventional rolling has been performed with a high draft exceeding 84 %.

Patent Literature 1: Japanese Patent Laying-Open No. 5-101723
Patent Literature 2: Japanese Patent No. 2592846 (Japanese Patent Laying-Open No. 1-30114)

### Disclosure of the Invention

### Problems to be Solved by the Invention

In the conventional method of manufacturing a superconducting wire, however, there have been the following problems: In rolling of the metal pipe charged with the raw material powder, pinholes have been formed in the metal pipe. When pinholes are formed, gas penetrates into the wire through the pinholes in the heat treatment, to result in no difference between the internal and external pressures of the wire. Consequently, there has been such a problem that formation of voids and blisters is insufficiently suppressed despite the heat treatment in the pressurizing atmosphere and no oxide superconducting wire having high superconductivity can be obtained.

When the oxide superconducting wire has been a multifilamentary wire, metals located between raw material powder portions have been so broken by rolling in the step of rolling the metal pipe charged with the raw material powder that oxide superconductor filaments have easily come into contact with each other. When the oxide superconductor filaments come into contact with each other, the oxide superconductor filaments, the metals and interfacial portions decrease. In general, current flows through the oxide superconductor filaments, the metals and the interfacial portions, and hence there has been such a problem that a critical current value decreases and superconductivity reduces. When the oxide superconductor filaments come into contact with each other, further, effects of the multifilamentary wire so reduce that there has been such a problem that AC loss increases and the superconductivity reduces when alternating current is fed to the oxide superconductor filaments.

Accordingly, an object of the present invention is to provide a method of manufacturing an oxide superconducting wire capable of improving superconductivity.

**Means for Solving the Problems**

The method of manufacturing an oxide superconducting wire according to the present invention comprises a step of preparing a wire formed by covering raw material powder for an oxide superconductor with a metal, a rolling step of rolling the wire and a heat treatment step of heat-treating the wire in a pressurizing atmosphere after the rolling step. The draft of the wire in the rolling step is at least 50 % and not more than 80 %.

According to the inventive method of manufacturing an oxide superconducting wire, the rolling step is so carried out with the draft of not more than 80 % lower than a general value that pinholes are hardly formed in the metal covering the raw material powder and formation of voids and blisters is sufficiently suppressed due to the heat treatment in the pressurizing atmosphere. When the oxide superconducting wire is a multifilamentary wire, the metal between raw material powder portions is so hardly broken that the oxide superconductor, the metal and an interfacial portion can be ensured and the critical current value hardly decreases. Further, AC loss hardly increases when alternating current is fed to the oxide superconductor. On the other hand, the wire is compressed when heat-treated in the pressurizing atmosphere, whereby the density of the oxide superconductor can consequently be improved. The density of the raw material powder can be sufficiently increased by carrying out the rolling step with the draft of at least 50 %. Thus, superconductivity of the oxide superconducting wire can be improved.

Preferably in the method of manufacturing an oxide superconducting wire according to the present invention, the draft of the wire in the rolling step is at least 60 %, more preferably at least 70 %.

Thus, pinholes are more hardly formed in the metal covering the raw material powder. When the oxide superconducting wire is a multifilamentary wire, further, the metal between oxide superconductors is more hardly broken.

The method of manufacturing an oxide superconducting wire according to the present invention preferably further comprises a re-rolling step of rolling the wire after the heat treatment step and a re-heat treatment step of heat-treating the wire in a pressurizing atmosphere after the re-rolling step. Thus, the sintering density of the oxide superconducting wire can be further improved, and the superconductivity can be further improved.

Preferably in the method of manufacturing an oxide superconducting wire according to the present invention, the wire is rolled while a side surface of the wire is fixed in the rolling step. Thus, the width of the oxide superconducting wire can be reduced. When the width of the oxide superconducting wire is small, AC loss decreases when the oxide superconducting wire receives a magnetic field in a direction perpendicular to both of the longitudinal direction and the width direction thereof Further, the density of the wire can be increased with the draft lower than the general value and the critical current value can be improved by restraining the side surface of the wire. If the wire is rolled with a general draft while the side surface portion thereof is fixed, there is a possibility that a pressure applied to the wire excessively increases to break the wire. However, the draft according to the present invention is lower than the general value, whereby the wire is not broken when rolled while the side surface portion thereof is restrained.

The method of manufacturing an oxide superconducting wire according to the present invention preferably further comprises a step of twisting the wire before the rolling step. Thus, the superconductivity of the oxide superconducting wire forming a twisted wire can be improved.

**Effects of the Invention**

According to the inventive method of manufacturing an oxide superconducting wire, the rolling step is so carried out with the draft of not more than 80 % lower than the general value that pinholes are hardly formed in the metal covering the raw material powder, and formation of voids and blisters is sufficiently suppressed due to the heat treatment in the pressurizing atmosphere. When the oxide superconducting wire is a multifilamentary wire, the metal between raw material powder portions is so hardly broken that the oxide superconductor, the metal and an interfacial portion can be ensured and the critical current value hardly decreases. Further, AC loss hardly increases when alternating current is fed to the oxide superconductor. On the other hand, the wire is compressed when heat-treated in the pressurizing atmosphere, whereby the density of the oxide superconductor can consequently be increased. The density of the raw material powder can be sufficiently increased by carrying out the rolling step with the draft of at least 50 %. Thus, the superconductivity of the oxide superconducting wire can be improved.

**Brief Description of the Drawings**

Fig. 1 is a partially fragmented perspective view schematically showing the structure of an oxide superconducting wire.
Fig. 2 is a diagram showing manufacturing steps for an oxide superconducting wire according to a first embodiment of the present invention.
Fig. 3 is a sectional view schematically showing a method of rolling a wire in the first embodiment of the present invention.
Fig. 4 is a partially fragmented perspective view showing the structure of a rolled wire in a conventional method of manufacturing an oxide superconducting wire.
Fig. 5 is a diagram showing manufacturing steps for an oxide superconducting wire according to a second embodiment of the present invention.
Fig. 6 is a diagram showing a method of rolling a wire in a third embodiment of the present invention.
Fig. 7 is a partially fragmented perspective view conceptually showing a structure of an oxide superconducting wire in a fourth embodiment of the present invention.
Fig. 8 is a diagram showing manufacturing steps for the oxide superconducting wire in the fourth embodiment of the present invention.
Fig. 9 is a sectional view schematically showing a state of twisting.
Fig. 10 is a sectional view conceptually showing another structure of the oxide superconducting wire in the fourth embodiment of the present invention.

**Description of Reference Signs**

1, 11, 21 oxide superconducting wire, 1a, 11a, 100 wire (multifilamentary wire), 2, 12 oxide superconductor filament, 3, 13 sheath portion, 12a, 102 raw material powder, 13a, 103 metal, 14 insulating film, 15 roll, 15a roll surface, 17 fixing member, 18 wire side surface, 19 wire upper surface, 20 wire lower surface, 110 pinhole, 111 break.

**Best Modes for Carrying Out the Invention**

Embodiments of the present invention are now described with reference to the drawings.

(First Embodiment)

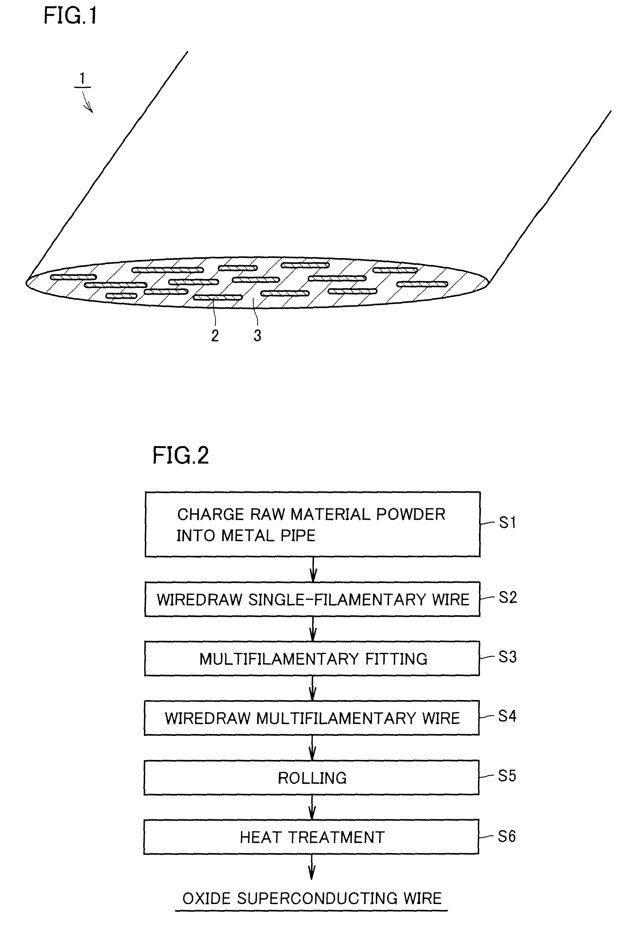

Fig. 1 is a partially fragmented perspective view schematically showing the structure of an oxide superconducting wire. Referring to Fig. 1, a multifilamentary oxide superconducting wire, for example, is described. An oxide superconducting wire 1 has a plurality of oxide superconductor filaments 2 extending in the longitudinal direction and a sheath portion 3 covering the same. The material for each of plurality of oxide superconductor filaments 2 preferably has a Bi-Pb-Sr-Ca-Cu-O-based composition, for example, and a material including a Bi2223 phase in which the atomic ratios of (bismuth and lead):strontium:calcium:copper are substantially expressed as 2:2:2:3 is optimum in particular. The material for sheath portion 3 is prepared from a metal such as silver or a silver alloy, for example.
While the multifilamentary wire has been described in the above, an oxide superconducting wire of a single-filamentary structure comprising a single oxide superconductor filament 2 covered with sheath portion 3 may alternatively be employed.
A method of manufacturing the aforementioned oxide superconducting wire is now described.
Fig. 2 is a diagram showing manufacturing steps for an oxide superconducting wire according to a first embodiment of the present invention. Referring to Fig. 2, raw material powder (precursor) for an oxide superconductor is first charged into a metal pipe (step S1). This raw material powder for the oxide superconductor is prepared from a material including a Bi2223 phase, for example. Silver or a silver alloy having high heat conductivity is preferably employed for the metal pipe. Thus, heat resulting from quenching partially caused in the superconductor can be swiftly removed from the metal pipe.
Then, the aforementioned wire is wiredrawn to a prescribed diameter, for preparing single-filamentary wires having cores of the precursor covered with the metal such as silver (step S2). Then, a large number of these single-filamentary wires are bundled and fitted into a metal pipe of a metal such as silver, for example (multifilamentary fitting: step S3). Thus, a wire of a multifilamentary structure (may hereinafter be simply referred to as a wire) having a large number of cores of the raw material powder is obtained.
Then, the wire of the multifilamentary structure is wiredrawn to a desired diameter, for preparing a multifilamentary wire having the raw material powder embedded in a sheath portion of silver, for example (step S4). Thus, a multifilamentary wire formed by covering the raw material powder for the oxide superconducting wire with the metal is obtained.

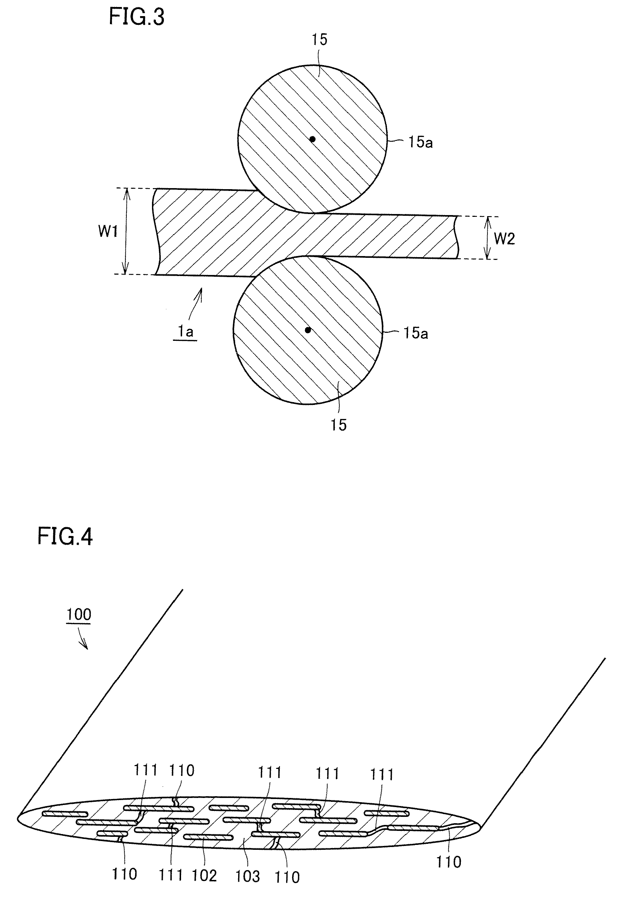

Then, this wire is rolled (step S5). Fig. 3 is a sectional view schematically showing a method of rolling the wire in the first embodiment of the present invention. Fig. 3 is a sectional view along the longitudinal direction of the wire. Referring to Fig. 3, rolling is a working method of passing a platelike or bar-like material through a plurality of (generally two) rotating rolls 15 for reducing the thickness or the sectional area thereof while molding the section into a target shape at the same time. In this rolling, a multifilamentary wire 1a is drawn into the space between plurality of rolls 15 due to frictional force from rolls 15, and deformed by compressive force received from surfaces 15a of rolls 15. The density of the raw material powder is increased by this rolling.

According to this embodiment, wire 1a is rolled with a draft of at least 50 % and not more than 80 % in the rolling (step S5) of wire 1a. Further, wire 1a is preferably rolled with a draft of at least 50 % and not more than 70 %, more preferably at least 50 % and not more than 60 %. The draft (%) is defined by the following expression:

$$[\text{Num } 1]$$

$$\text{Draft } (\%) = (1 - \text{thickness W2 of wire after rolling/thickness W1 of wire before rolling}) \times 100$$

Referring to Fig. 2, the wire is heat-treated in a pressurizing atmosphere (step S6). This heat treatment is performed in a pressurizing atmosphere of at least 1 MPa and less than 50 MPa at a temperature of about 830°C, for example. An oxide superconducting phase is generated from the raw material powder due to the heat treatment, to form oxide superconducting filaments 2 (Fig. 1). The oxide superconducting wire shown in Fig. 1 is obtained through the aforementioned manufacturing steps.

The inventors have found that an oxide superconducting wire having high superconductivity can be obtained by rolling a wire with a draft of at least 50 % and not more than 80 %. This is now described.

Fig. 4 is a partially fragmented perspective view schematically showing the structure of a rolled wire in a conventional method of manufacturing an oxide superconducting wire. As shown in Fig. 4, a wire has been rolled with a high draft exceeding 84 % in a conventional wire 100, whereby pinholes 110 have been formed in a metal 103 covering raw material powder 102, and pressurizing gas has penetrated into wire 100 through pinholes 110 in heat treatment. Further, the wire has been rolled with the high draft, whereby breaks 111 have been so formed in metal 103 between raw material powder portions 102 that oxide superconductor filaments have easily come into contact with each other when wire 100 has been rolled.

While the density of the raw material powder after the rolling (step S5) is lower than the general value in the manufacturing method according to this embodiment, the wire is compressed through the heat treatment in the pressurizing atmosphere (step S6) for increasing the density of the raw material powder. Therefore, the density of the superconducting filaments can consequently be increased although the wire is rolled with the draft of not more than 80 % lower than the conventional draft.

In the manufacturing method according to this embodiment, the wire is rolled with the draft of not more than 80 % lower than the conventional draft, whereby pinholes are hardly formed in the metal covering the raw material powder when the wire is rolled. Therefore, formation of voids and blisters is sufficiently suppressed due to the heat treatment in the pressurizing atmosphere. Further, the wire is so rolled with the draft lower than the conventional value that the metal between the raw material powder portions is hardly broken and the oxide superconductor filaments hardly come into contact with each other. Therefore, the superconductivity does not reduce, and no AC loss increases when alternating current is fed to the oxide superconductor filaments. Thus, the superconductivity can be improved.

In the aforementioned method, the draft of the wire in the rolling (step S5) is preferably not more than 70 %, more preferably not more than 60 %. Thus, pinholes are more hardly formed in sheath portion 3. Further, sheath portion 3 between oxide superconductor filaments 2 is more hardly broken.

(Second Embodiment)

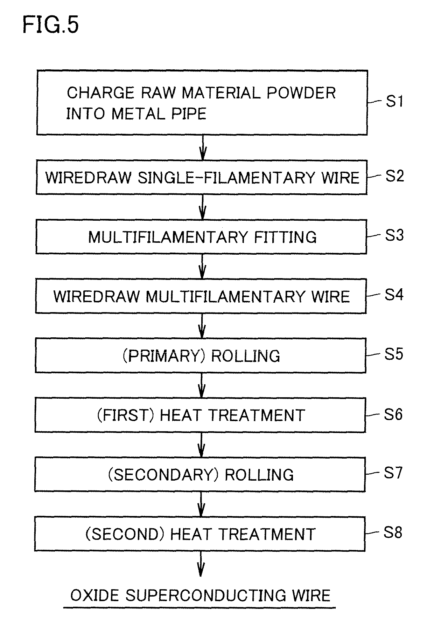

Fig. 5 is a diagram showing manufacturing steps for an oxide superconducting wire according to a second embodiment of the present invention. Referring to Fig. 5, a wire is rolled (primary rolling: step S5), the wire is heat-treated in a pressurizing atmosphere (first heat treatment: step S6), and the wire is thereafter rolled again (secondary rolling:

step S7). The current draft is not particularly restricted. Thus, voids formed in the first heat treatment are removed by performing the secondary rolling.

Then, the wire is heat-treated at a temperature of 820°C, for example (second heat treatment: step S8). At this time, the wire, preferably heat-treated in a pressurizing atmosphere, may be heat-treated under the atmospheric pressure. In the second heat treatment, an oxide superconducting phase is converted to a single phase simultaneously with progress of sintering of the oxide superconducting phase. The oxide superconducting wire shown in Fig. 1 is obtained through the aforementioned manufacturing steps.

The remaining method of manufacturing an oxide superconducting wire is similar to the manufacturing method according to the first embodiment shown in Fig. 2, and hence redundant description is not repeated.

In the method of manufacturing an oxide superconducting wire according to this embodiment, the wire is rolled (step S7) after the heat treatment (step S6), and the wire is thereafter heat-treated (step S8). Thus, sintering density of the oxide superconducting wire can be improved, and superconductivity can be further improved.

While the case of alternately performing the rolling and the heat treatment twice respectively has been shown in this embodiment, the frequencies of the rolling and the heat treatment are not limited in the present invention but the rolling and the heat treatment may further be repeated.

(Third Embodiment)

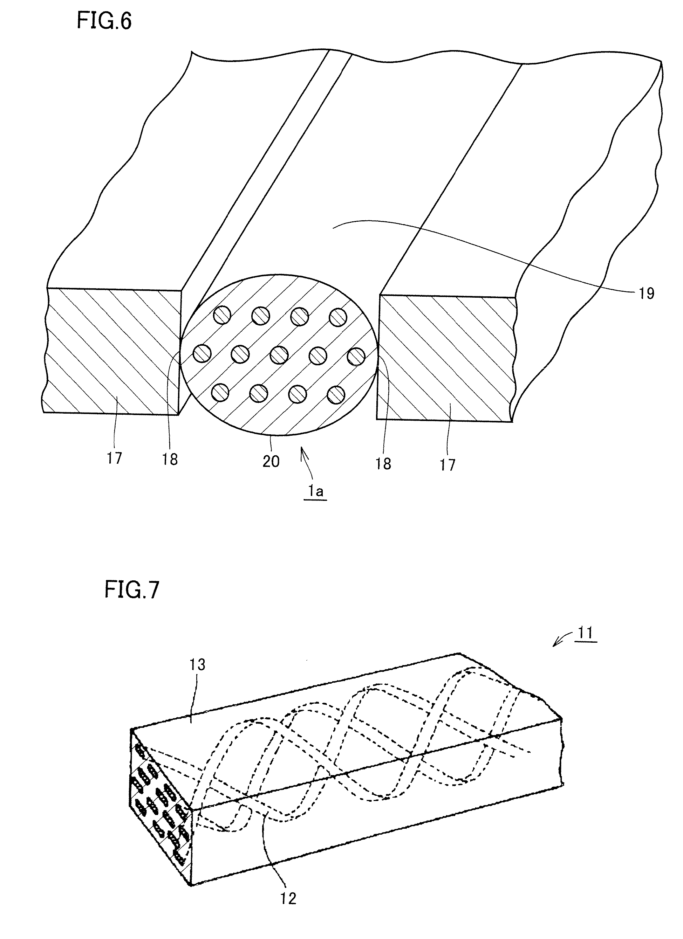

Fig. 6 is a diagram showing a method of rolling a wire in a third embodiment of the present invention. Fig. 6 is a sectional view perpendicular to the longitudinal direction of the wire. Referring to Fig. 6, a wire 1a is rolled while side surfaces 18 thereof are fixed with the respective ones of fixing members 17 in rolling (step S5). Side surfaces 18 of wire 1a denote faces of wire 1a substantially perpendicular to an upper surface 19 and a lower surface 20 when upper surface 19 and lower surface 20 of wire 1a are pressurized by rolls 15 (Fig. 3).

The remaining method of manufacturing an oxide superconducting wire is similar to the manufacturing method according to the first embodiment shown in Fig. 2 or the second embodiment shown in Fig. 5, and hence redundant description is not repeated.

In the method of manufacturing an oxide superconducting wire according to this embodiment, wire 1a is rolled while side surfaces 18 thereof are fixed in the rolling (step S5). Thus, the width (transverse length in Fig. 6) of an oxide superconducting wire 1 can be reduced. When the width of oxide superconducting wire 1 is small, AC loss decreases when oxide superconducting wire 1 receives a magnetic field in a direction (vertical direction in Fig. 6) perpendicular to both of the longitudinal direction and the width direction thereof

(Fourth Embodiment)

The manufacturing method in the case where oxide superconductor filaments 2 extend in the longitudinal direction of oxide superconducting wire 1 and oxide superconducting wire 1 is in the form of a tape as shown in Fig. 1 has been described in each of the first to third embodiments. The feature of the oxide superconducting wire shown in Fig. 1 resides in that the same has high critical current density. However, the manufacturing method according to the present invention can also be applied to a method of manufacturing a twisted oxide superconducting wire, for example, in addition to the method of manufacturing the oxide superconducting wire shown in Fig. 1. In this embodiment, a method of manufacturing a twisted oxide superconducting wire is described.

Fig. 7 is a partially fragmented perspective view conceptually showing a structure of an oxide superconducting wire according to a fourth embodiment of the present invention. As shown in Fig. 7, a twisted oxide superconducting wire 11 has a plurality of oxide superconductor filaments 12 extending in the longitudinal direction and a sheath portion 13 covering the same. Oxide superconductor filaments 12 are spirally twisted along the longitudinal direction of oxide superconducting wire 11. A method of manufacturing this twisted oxide superconducting wire 11 is now described.

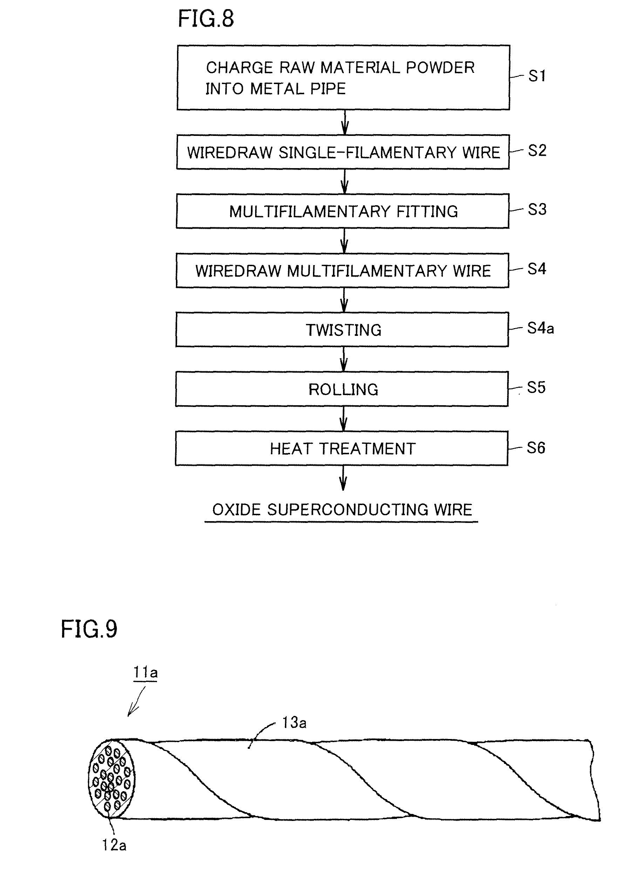

Fig. 8 is a diagram showing manufacturing steps for the oxide superconducting wire according to the fourth embodiment of the present invention. Referring to Fig. 8, the wire is twisted (step S4a) after preparation of a multifilamentary wire by wiredrawing (step S4) and before primary rolling (step S5) in the method of manufacturing twisted oxide superconducting wire 11.

Fig. 9 is a sectional view showing the state of twisting. Referring to Fig. 9, a multifilamentary wire 11a having raw material powder 12a and a metal 13a is shown. Wire 11a is so twisted that twist pitches are 500 mm, 100 mm, 50 mm and 10 mm respectively, for example. The wire is rolled after the twisting (step S5).

The remaining manufacturing method is substantially similar to the manufacturing method according to the third embodiment, and hence redundant description is not repeated.

In the method of manufacturing an oxide superconducting wire according to this embodiment, the wire is twisted (step S4a) before rolling of the wire (step S5).

According to the method of manufacturing oxide superconducting wire 11 according to this embodiment, twisted oxide superconducting wire 11 can be obtained. The twisted oxide superconducting wire has such an effect that AC loss can be reduced. Formation of blisters in the twisted oxide superconducting wire can be suppressed and critical current density can be improved by applying the present invention to the method of manufacturing a twisted oxide superconducting wire. In particular, AC loss can be remarkably reduced by rolling the twisted wire while fixing the side surfaces thereof in the rolling (step S5).

According to the aforementioned manufacturing method, the metal between oxide superconductor filaments 12 is so hardly broken that the number of oxide superconductor filaments 12 included in oxide superconducting wire 11 can be increased by narrowing the intervals between oxide superconductor filaments 12. Thus, the effect of reducing AC loss can be attained.

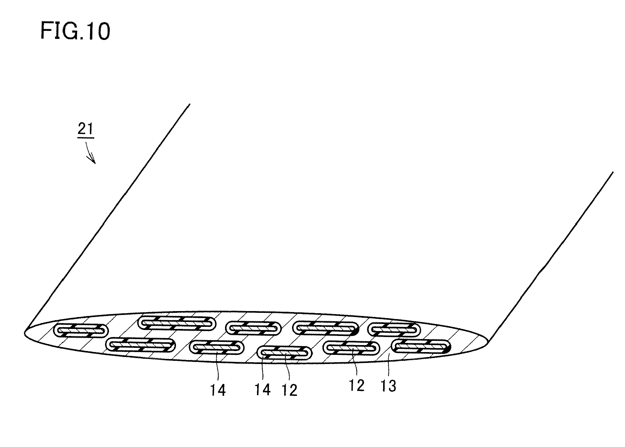

Twisted oxide superconducting wire 11 having the structure shown in Fig. 7 has been shown in this embodiment. However, the present invention can also be applied to an oxide superconducting wire 21 having a structure shown in Fig. 10, for example, in addition to this case. Referring to Fig. 10, twisted oxide superconducting wire 21 comprises a plurality of oxide superconductor filaments 12, a sheath portion 13 and insulating films 14. Insulating films 14 cover the peripheries of the respective ones of plurality of oxide superconductor filaments 12, and sheath portion 13 covers insulating films 14. In this oxide superconducting wire 21, insulating films 14 function as electric barriers, whereby AC loss can be further reduced.

Examples of the present invention are now described.

(Example 1)

In this Example, the effect attained by rolling the wire with the draft of not more than 80 % (step S5) has been examined. More specifically, the oxide superconducting wire shown in Fig. 1 was prepared by the manufacturing method shown in the first embodiment. In the rolling (step S5), however, the draft was varied in the range of 50 % to 85 %, for rolling round wires of 1.6 mm in diameter respectively. In the heat treatment (step S6), the wires were heat-treated for 30 hours in an atmosphere of a temperature of 830°C, a total pressure of 30 MPa (pressurizing atmosphere) and an oxygen partial pressure of 8 kPa. Critical current values (A) were measured as to the oxide superconducting wires obtained in this manner. Table 1 shows the results.

Table 1

| Primary Draft | 50% | 60% | 70% | 80% | 85% |
|---|---|---|---|---|---|
| Critical Current Value (A) | 110 | 115 | 118 | 115 | 105 |

As shown in Table 1, the critical current value was 105 A when the draft was 85 %, while the critical current value was 115 A when the draft was 80 % and the critical current value was 118 A when the draft was 70 %. Further, the critical current value was 115 A when the draft was 60 %, and the critical current value was 110 A when the draft was 50 %. It is understood from the above results that the superconductivity is improved by setting the draft to at least 50 % and not more than 80 %. It is also understood that the superconductivity is further improved by setting the draft preferably to at least 60 %, more preferably to at least 70 %.

(Example 2)

In this Example, the effect attained by the secondary rolling (step S7) and the second heat treatment (step S8) has been examined. More specifically, the oxide superconducting wire shown in Fig. 1 was prepared by the manufacturing method shown in the second embodiment. In the primary rolling (step S5), however, the draft was varied in the range of 50 % to 85 %, for rolling round wires of 1.6 mm in diameter respectively. In the first heat treatment (step S6), the wires were heat-treated for 30 hours in an atmosphere of a temperature of 830°C, a total pressure of 30 MPa (pressurizing atmosphere) and an oxygen partial pressure of 8 kPa. In the secondary rolling (step S7), the draft (draft with reference to the thicknesses of the wires immediately before the secondary rolling) was set to 5 % for rolling the wires. In the second heat treatment (step S8), further, the wires were heat-treated for 50 hours in an atmosphere of a temperature of 820°C, a total pressure of 30 MPa (pressurizing atmosphere) and an oxygen partial pressure of 8 kPa. Critical current values (A) were measured as to the oxide superconducting wires obtained in this manner. Table 2 shows the results.

Table 2

| Primary Draft | 50% | 60% | 70% | 80% | 85% |
|---|---|---|---|---|---|
| Critical Current Value (A) | 136 | 141 | 144 | 140 | 130 |

As shown in Table 2, the critical current value was 130 A when the draft was 85 %, while the critical current value was 140 A when the draft was 80 % and the critical current value was 144 A when the draft was 70 %. Further, the critical current value was 141 A when the draft was 60 %, and the critical current value was 136 A when the draft was 50 %. It is understood from the above results that the critical current value is improved by setting the draft to at least 50 % and not more than 80 %. Comparing the results of Example 1 and the results of this Example with each other, it is understood that the superconductivity is further improved by performing the secondary rolling (step S7) and the second heat treatment (step S8).

(Example 3)

In this Example, the effect attained by performing the heat treatment in the pressurizing atmosphere has been examined. More specifically, the first heat treatment (step S6) was performed with a total pressure of 0.1 MPa (atmosphere), and the second heat treatment (step S8) was performed with a total pressure of 30 MPa (pressurizing atmosphere). In the rolling (step S5), the draft was varied in the range of 50 % to 85 %, for rolling round wires of 1.6 mm in diameter respectively. The remaining method of manufacturing oxide superconducting wires was rendered similar to the manufacturing method of Example 2. Critical current values (A) were measured as to oxide superconducting wires obtained in this manner. Table 3 shows the results.

Table 3

| Primary Draft | 50% | 60% | 70% | 80% | 85% |
|---|---|---|---|---|---|
| Critical Current Value (A) | 60 | 90 | 120 | 130 | 120 |

As shown in Table 3, the critical current value was 120 A when the draft was 85 %, and the critical current value was 130 A when the draft was 80 %. Further, the critical current value was 120 A when the draft was 70 %, the critical current value was 90 A when the draft was 60 %, and the critical current value was 60 A when the draft was 50 %. It is understood from the above results that the critical current value is not improved if the heat treatment is performed not in the pressurizing atmosphere but in the atmosphere, also when the draft is set to at least 50 % and not more than 80 %. Comparing the results of Example 2 and the results of this Example with each other, therefore, it is understood necessary to roll the wire with the draft of not more than 80 % and heat-treat the wire in the pressurizing atmosphere, in order to improve the superconductivity of the oxide superconducting wire.

(Example 4)

In this Example, the effect attained by rolling the wire while fixing the side surfaces thereof has been examined. More specifically, the oxide superconducting wire shown in Fig. 1 was prepared by the manufacturing method shown in the third embodiment. In the rolling (step S5), however, the draft was varied in the range of 50 % to 85 % while fixing the widths of wires, for rolling round wires of 1.6 mm in diameter respectively. In the first heat treatment (step S6), the wires were heat-treated for 30 hours in an atmosphere of a temperature of 830°C, a total pressure of 0.1 MPa (atmosphere) and an oxygen partial pressure of 8 kPa. In the secondary rolling (step S7), the draft was set to 10 % for rolling the wires. In the second heat treatment (step S8), further, the wires were heat-treated for 50 hours in an atmosphere of a temperature of 820°C, a total pressure of 30 MPa and an oxygen partial pressure of 8 kPa. Critical current values (A) were measured as to oxide superconducting wires obtained in this manner. Table 4 shows the results.

Table 4

| Primary Draft | 50% | 60% | 70% | 80% | 85% |
|---|---|---|---|---|---|
| Critical Current Value (A) | 90 | 120 | 125 | 110 | 90 |

As shown in Table 4, the critical current value was 90 A when the draft was 85 %, while the critical current value was 110 A when the draft was 80 % and the critical current value was 125 A when the draft was 70 %. Further, the critical current value was 120 A when the draft was 60 %, and the critical current value was 90 A when the draft was 50 %. It is understood from the above results that the superconductivity is improved by setting the draft to at least 50 % and not more than 80 %. Comparing the results of Example 2 and the results of this Example with each other, it is understood that the superconductivity is improved by rolling the wire while fixing the side surfaces thereof

EP 1 814 127 A1

(Example 5)

In this Example, the effect attained by rolling the twisted oxide superconducting wire while fixing the side surfaces thereof has been examined. More specifically, twisted oxide superconducting wire 11 shown in Fig. 7 was prepared by the manufacturing method shown in the fourth embodiment. In the twisting (step S4a), however, wire 11a having 127 raw material powder portions 12a (oxide superconductor filaments 12) was twisted at a twist pitch of 8 mm. The remaining method of manufacturing an oxide superconducting wire was rendered similar to the manufacturing method according to Example 4. Critical current values (A) and AC loss were measured as to oxide superconducting wires obtained in this manner. As to AC loss, AC loss in a case of rolling the wire with the draft of 80 % was regarded as 100 %. Table 5 shows the results.

Table 5

| Primary Draft | 50% | 60% | 70% | 80% | 85% |
| --- | --- | --- | --- | --- | --- |
| Critical Current Value (A) | 88 | 117 | 121 | 105 | 80 |
| AC Loss | 15% | 20% | 30% | 100% | 100% |

As shown in Table 5, the critical current value was 80 A when the draft was 85 %, while the critical current value was 105 A when the draft was 80 % and the critical current value was 121 A when the draft was 70 %. Further, the critical current value was 117 A when the draft was 60 %, and the critical current value was 88 A when the draft was 50 %. AC loss was 30 % when the draft was 70 %, 20 % when the draft was 60 % and 15 % when the draft was 50 %. It is understood from the above results that AC loss is remarkably reduced by setting the draft to not more than 70 %, preferably not more than 60 %. It is also understood from the above results that the superconductivity is further improved by rolling the twisted oxide superconducting wire while fixing the side surfaces thereof

The embodiments and Examples disclosed in the above are to be considered as illustrative in all points and not restrictive. The scope of the present invention is shown not by the above embodiments and Examples but by the scope of claim for patent, and intended to include all corrections and modifications within the meaning and range equivalent to the scope of claim for patent.

**Claims**

1. A method of manufacturing an oxide superconducting wire (1), comprising:

   a step (S 1 to S4) of preparing a wire formed by covering raw material powder for an oxide superconductor with a metal;
   a rolling step (S5) of rolling said wire; and
   a heat treatment step (S6) of heat-treating said wire in a pressurizing atmosphere after said rolling step, wherein the draft of said wire in said rolling step is at least 50 % and not more than 80 %.

2. The method of manufacturing an oxide superconducting wire according to claim 1, wherein
   the draft of said wire in said rolling step is at least 60 %.

3. The method of manufacturing an oxide superconducting wire (1) according to claim 2, wherein
   the draft of said wire in said rolling step (S5) is at least 70 %.

4. The method of manufacturing an oxide superconducting wire (1) according to claim 1, further comprising:

   a re-rolling step (S7) of rolling said wire after said heat treatment step (S6), and
   a re-heat treatment step (S8) of heat-treating said wire after said re-rolling step.

5. The method of manufacturing an oxide superconducting wire (1) according to claim 1, rolling said wire (1a) while fixing a side surface (18) of said wire (1a) in said rolling step (S5).

6. The method of manufacturing an oxide superconducting wire (1) according to claim 5, further comprising a step (S4a) of twisting said wire (11a) before said rolling step (S5).

FIG.1

FIG.2

| CHARGE RAW MATERIAL POWDER INTO METAL PIPE | S1 |
| WIREDRAW SINGLE-FILAMENTARY WIRE | S2 |
| MULTIFILAMENTARY FITTING | S3 |
| WIREDRAW MULTIFILAMENTARY WIRE | S4 |
| ROLLING | S5 |
| HEAT TREATMENT | S6 |

OXIDE SUPERCONDUCTING WIRE

FIG.3

FIG.4

FIG.5

```
┌─────────────────────────────────┐
│ CHARGE RAW MATERIAL POWDER      │── S1
│ INTO METAL PIPE                 │
└─────────────────────────────────┘
              │
              ▼
┌─────────────────────────────────┐
│ WIREDRAW SINGLE-FILAMENTARY WIRE│── S2
└─────────────────────────────────┘
              │
              ▼
┌─────────────────────────────────┐
│ MULTIFILAMENTARY FITTING        │── S3
└─────────────────────────────────┘
              │
              ▼
┌─────────────────────────────────┐
│ WIREDRAW MULTIFILAMENTARY WIRE  │── S4
└─────────────────────────────────┘
              │
              ▼
┌─────────────────────────────────┐
│ (PRIMARY) ROLLING               │── S5
└─────────────────────────────────┘
              │
              ▼
┌─────────────────────────────────┐
│ (FIRST) HEAT TREATMENT          │── S6
└─────────────────────────────────┘
              │
              ▼
┌─────────────────────────────────┐
│ (SECONDARY) ROLLING             │── S7
└─────────────────────────────────┘
              │
              ▼
┌─────────────────────────────────┐
│ (SECOND) HEAT TREATMENT         │── S8
└─────────────────────────────────┘
              │
              ▼
     OXIDE SUPERCONDUCTING WIRE
```

FIG.6

17    18    20    18    17

1a

19

FIG.7

11

13

12

## FIG.8

| CHARGE RAW MATERIAL POWDER INTO METAL PIPE | — S1 |

↓

| WIREDRAW SINGLE-FILAMENTARY WIRE | — S2 |

↓

| MULTIFILAMENTARY FITTING | — S3 |

↓

| WIREDRAW MULTIFILAMENTARY WIRE | — S4 |

↓

| TWISTING | — S4a |

↓

| ROLLING | — S5 |

↓

| HEAT TREATMENT | — S6 |

↓

OXIDE SUPERCONDUCTING WIRE

## FIG.9

FIG.10

<table>
<tr><td colspan="2"><b>INTERNATIONAL SEARCH REPORT</b></td><td>International application No.<br>PCT/JP2005/020918</td></tr>
</table>

| A. CLASSIFICATION OF SUBJECT MATTER |
|---|
| **H01B13/00**(2006.01), **H01B12/10**(2006.01) |
| According to International Patent Classification (IPC) or to both national classification and IPC |

| B. FIELDS SEARCHED |
|---|
| Minimum documentation searched (classification system followed by classification symbols)<br>H01B12/10, H01B13/00 |

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| X<br>Y<br>A | JP 2002-93252 A (Sumitomo Electric Industries, Ltd.),<br>29 March, 2002 (29.03.02),<br>Par. Nos. [0040] to [0046], [0050] to [0054]<br>& EP 1172868 A2 & US 2002/022576 A1<br>& US 2003/059734 A1 | 1-4<br>6<br>5 |
| X<br>Y<br>A | WO 2003/100795 A1 (Sumitomo Electric Industries, Ltd.),<br>04 December, 2003 (04.12.03),<br>Page 7, line 48 to page 9, line 16<br>& EP 1508904 A1 & US 2004/237294 A1 | 1-4<br>6<br>5 |

☒ Further documents are listed in the continuation of Box C.   ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>15 February, 2006 (15.02.06) | Date of mailing of the international search report<br>28 February, 2006 (28.02.06) |
|---|---|
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

International application No.

PCT/JP2005/020918

C (Continuation).  DOCUMENTS CONSIDERED TO BE RELEVANT

| Category* | Citation of document, with indication, where appropriate, of the relevant passages | Relevant to claim No. |
|---|---|---|
| Y | JP 2001-6455 A  (The Furukawa Electric Co., Ltd.), 12 January, 2001 (12.01.01), Claim 3; Par. No. [0005] (Family: none) | 6 |
| Y | JP 7-105753 A  (Sumitomo Electric Industries, Ltd.), 21 April, 1995 (21.04.95), Claim 11; Par. No. [0001] & EP 638942 A1          & US 6158106 A & US 6272732 B1 | 6 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5101723 A
- JP 2592846 B
- JP 1030114 A